# EUROPEAN PATENT SPECIFICATION

(11) **EP 4 156 307 B1**
(45) Date of publication and mention of the grant of the patent: **11.11.2026**
(21) Application number: 22164154.1
(22) Date of filing: 24.03.2022
(51) Int. Cl.: H10F 19/20, H10F 71/00

(54) **HETEROJUNCTION CELL AND FABRICATION METHODS THEREOF**
HETEROÜBERGANGSZELLE UND HERSTELLUNGSVERFAHREN DAFÜR
CELLULE À HÉTÉROJONCTION ET SES PROCÉDÉS DE FABRICATION

(30) Priority: 28.09.2021 CN 202111140520
(43) Date of publication of application: 29.03.2023
(73) Proprietor: Huaneng Clean Energy Research Institute, Beijing 102209 (CN); Huaneng Group R&D Center Co., Ltd., 100031 Xicheng District Beijing (CN)
(72) Inventor: YU, Xiangrui, 102209 Beijing (CN); PENG, Wenbo, 102209 Beijing (CN); XIAO, Ping, 102209 Beijing (CN); ZHAO, Dongming, 102209 Beijing (CN); TIAN, Hongxiang, 102209 Beijing (CN); LUO, Lizhen, 102209 Beijing (CN)
(74) Representative: Di Giovine, Paolo

(56) References cited:
- CN-A- 108 110 079
- US-A- 4 330 680

## Description

### FIELD

The present invention relates to a field of solar cell, and more particularly to a heterojunction cell and fabrication methods thereof.

### BACKGROUND

Heterojunction solar cell, as one of the most potential next-generation silicon-based cells, has a high theoretical energy conversion efficiency, excellent bi-facial proprieties and less crystalline silicon materials, and may be fabricated in a non-high temperature environment. However, in a related art, a transparent conductive film covering the heterojunction cell generally has a high resistivity, which affects the efficiency of the heterojunction cell. In addition, in fabricating the heterojunction cell, the transparent conductive film will be damaged by the high temperature, resulting in difficulties in the cutting process and damages on the film near a position where the cutting happens, which increases a processing cost and negatively affects a cell to module (CTM) ratio (i.e., a ratio of the power of the module after integration of solar cells relative to a sum of the initial power of the solar cells) of a heterojunction half-cell or laminate module.

Document US 4 330 680 A discloses a monolithic integrated series-connected cell based on high-ohmic Si with a plurality of p/n strips and metal tracks on both sides of the substrate.

### SUMMARY

Embodiments of the present disclosure seek to solve at least one of the problems existing in the related art to at least some extent.

In a first aspect of the present disclosure, a heterojunction cell is provided, which has a high energy conversion efficiency, and a photovoltaic module composed of the heterojunction cell(s) may be easily encapsulated and packaged.

In a second aspect of the present disclosure, a method for fabricating a heterojunction cell is provided. The invention is defined in independent claims 1, 11 and 14. Preferred embodiments are defined in the dependent claims.

In the present invention, the heterojunction cell includes: a N-type single crystal silicon layer; a first intrinsic amorphous silicon passivation layer, a first amorphous silicon layer and a plurality of first transparent conductive layers deposited on a first surface of the N-type single crystal silicon layer, respectively; and a second intrinsic amorphous silicon passivation layer, a second amorphous silicon layer and a plurality of second transparent conductive layer deposited on a second surface of the N-type single crystal silicon layer, respectively. The first amorphous silicon layer includes a first P-type amorphous silicon layer and a first N-type amorphous silicon layer, and the second amorphous silicon layer includes a second P-type amorphous silicon layer with an equal number to and in one-to-one correspondence with the first N-type amorphous silicon layer and a second N-type amorphous silicon layer with an equal number to in one-to-one correspondence with the first P-type amorphous silicon layer. At least one of the number of the first P-type amorphous silicon layers and the number of the first N-type amorphous silicon layers is more than 1. The first P-type amorphous silicon layer and the first N-type amorphous silicon layer are interleaved at intervals in a longitudinal direction of the N-type single crystal silicon layer. The plurality of the first transparent conductive layers are spaced apart from each other in the longitudinal direction of the N-type single crystal silicon layer, and configured to electrically connect any one of the first P-type amorphous silicon layers to an adjacent first N-type amorphous silicon layer at a first side. The plurality of the second transparent conductive layers are spaced apart from each other in the longitudinal direction of the N-type single crystal silicon layer, and configured to electrically connect any one of the second N-type amorphous silicon layers to an adjacent second P-type amorphous silicon layer at a second side. An orientation of the first side is opposite to that of the second side.

According to some embodiments of the present disclosure, in the heterojunction cell, the first P-type amorphous silicon layer and the corresponding second N-type amorphous silicon layer form a first cell segment with a certain voltage, and the first N-type amorphous silicon layer and the corresponding second P-type amorphous silicon layer may form a second cell segment with a certain voltage. The first cell segment is connected to the second cell segment in series by the first transparent conductive layers and the second transparent conductive layers. In this way, the heterojunction cell in the present disclosure has a configuration of elements/segments connected in series inside the heterojunction cell, and has an increased open-circuit voltage and a decreased short-circuit current, and the photovoltaic module composed of the heterojunction cell(s) may be easily encapsulated and packaged. In addition, compared with the photovoltaic modules in the related art, in a same size, the photovoltaic module composed of the heterojunction cell in the present disclosure need fewer connection points, resulting in smaller resistance, and thus a less power loss caused by the resistance under a same illumination condition and a higher energy conversion efficiency.

In the present invention, the heterojunction cell further includes: a third intrinsic amorphous silicon passivation layer, deposited on a first surface of the first intrinsic amorphous silicon passivation layer; and a fourth intrinsic amorphous silicon passivation layer, deposited on a second surface of the second intrinsic amorphous silicon passivation layer. The third intrinsic amorphous silicon passivation layer includes a first spacer between the first P-type amorphous silicon layer and the adjacent first N-type amorphous silicon layer, and the fourth intrinsic amorphous silicon passivation layer includes a second spacer between the second P-type amorphous silicon layer and the adjacent second N-type amorphous silicon layer.

The third intrinsic amorphous silicon passivation layers have an equal number to and are in one-to-one correspondence with the first P-type amorphous silicon layers. The fourth intrinsic amorphous silicon passivation layers have an equal number to and are in one-to-one correspondence with the second P-type amorphous silicon layers.

In an embodiment of the present disclosure, the number of the first P-type amorphous silicon layers adjacent to one first N-type amorphous silicon layer is equal to the number of the first spacers on a respective third intrinsic amorphous silicon passivation layer. The number of the second P-type amorphous silicon layers adjacent to one second N-type amorphous silicon layer is equal to the number of the second spacers on a respective fourth intrinsic amorphous silicon passivation layer.

In an embodiment of the present disclosure, a first surface of the first P-type amorphous silicon layer, a first surface of the first N-type amorphous silicon layer and a first surface of the first spacer are coplanar, and a second surface of the second P-type amorphous silicon layer, a second surface of the second N-type amorphous silicon layer and a second surface of the second spacer are coplanar.

In an embodiment of the present disclosure, the N-type single crystal silicon layer, the first intrinsic amorphous silicon passivation layer and the second intrinsic amorphous silicon passivation layer and are aligned in the longitudinal direction of the N-type single crystal silicon layer.

In an embodiment of the present disclosure, the first P-type amorphous silicon layer and the first N-type amorphous silicon layer are arranged at equal intervals in the longitudinal direction of the N-type single crystal silicon layer, and the second P-type amorphous silicon layer and the second N-type amorphous silicon layer are arranged at equal intervals in the longitudinal direction of the N-type single crystal silicon layer.

In an embodiment of the present disclosure, an interval between the first P-type amorphous silicon layer and the first N-type amorphous silicon layer is equal to that between the second P-type amorphous silicon layer and the second N-type amorphous silicon layer.

In an embodiment of the present disclosure, the first P-type amorphous silicon layers and the first N-type amorphous silicon layers have an equal number.

In an embodiment of the present disclosure, a first metal grid line is disposed on a first surface of each of the first transparent conductive layers, and a second metal grid line is disposed on a second surface of each of the second transparent conductive layers.

In an embodiment of the present disclosure, the first transparent conductive layers and the second transparent conductive layers are Ag nanowire transparent conductive layers.

In the present invention, a first method for fabricating a heterojunction cell includes: depositing a first intrinsic amorphous silicon passivation layer on a first surface of a N-type single crystal silicon layer, and depositing a second intrinsic amorphous silicon passivation layer on a second surface of the N-type single crystal silicon layer; depositing a P-type amorphous silicon layer on a first surface of the first intrinsic amorphous silicon passivation layer and on a second surface of the second intrinsic amorphous silicon passivation layer; providing a first mask on the first surface and the second surface of the N-type single crystal silicon layer; etching the P-type amorphous silicon layers to form a first P-type amorphous silicon layer and a second P-type amorphous silicon layer, respectively; depositing a third intrinsic amorphous silicon passivation layer at etching positions on the first surface of the N-type single crystal silicon layer and depositing a fourth intrinsic amorphous silicon passivation layer at etching positions on the second surface of the N-type single crystal silicon layer; depositing a first N-type amorphous silicon layer on a first surface of the third intrinsic amorphous silicon passivation layer, and depositing a second N-type amorphous silicon layer on a second surface of the fourth intrinsic amorphous silicon passivation layer; removing the first masks; providing a second mask on the first surface and the second surface of the N-type single crystal silicon layer; depositing a first transparent conductive layer on the first surface of the N-type single crystal silicon layer and depositing a second transparent conductive layer on the second surface of the N-type single crystal silicon layer; and forming a first metal grid line on a first surface of the first transparent conductive layer, and forming a second metal grid line on a second surface of the second transparent conductive layer.

**In** an embodiment of the present disclosure, when the P-type amorphous silicon layers are etched, the first intrinsic amorphous silicon passivation layer and the second intrinsic amorphous silicon passivation layer are etched to obtain a first groove with a depth greater than a thickness of the P-type amorphous silicon layer.

**In** an embodiment of the present disclosure, the first metal grid line is printed or electroplated on the first surface of the first transparent conductive layer, and the second metal grid line is printed or electroplated on the second surface of the second transparent conductive layer.

In the present invention, a second method for fabricating a heterojunction cell includes: depositing a first intrinsic amorphous silicon passivation layer on a first surface of a N-type single crystal silicon layer, and depositing a second intrinsic amorphous silicon passivation layer on a second surface of the N-type single crystal silicon layer; depositing a N-type amorphous silicon layer on a first surface of the first intrinsic amorphous silicon passivation layer and on a second surface of the second intrinsic amorphous silicon passivation layer; providing a first mask on the first surface and the second surface of the N-type single crystal silicon layer; etching the N-type amorphous silicon layers to form a first N-type amorphous silicon layer and a second N-type amorphous silicon layer, respectively; depositing a third intrinsic amorphous silicon passivation layer at etching positions on the first surface of the N-type single crystal silicon layer and depositing a fourth intrinsic amorphous silicon passivation layer at etching positions on the second surface of the N-type single crystal silicon layer; depositing a first P-type amorphous silicon layer on a first surface of the third intrinsic amorphous silicon passivation layer, and depositing a second P-type amorphous silicon layer on a second surface of the fourth intrinsic amorphous silicon passivation layer; removing the first masks; providing a second mask on the first surface and the second surface of the N-type single crystal silicon layer; depositing a first transparent conductive layer on the first surface of the N-type single crystal silicon layer and depositing a second transparent conductive layer on the second surface of the N-type single crystal silicon layer; and forming a first metal grid line on a first surface of the first transparent conductive layer, and forming a second metal grid line on a second surface of the second transparent conductive layer.

### BRIEF DESCRIPTION OF THE DRAWINGS

FIG 1 is a schematic diagram showing a heterojunction cell according to an embodiment of the present disclosure.
FIG 2 is a schematic diagram showing components in a first operation of a method for fabricating a heterojunction cell according to an embodiment of the present disclosure.
FIG 3 is a schematic diagram showing components in a second operation of a method for fabricating a heterojunction cell according to an embodiment of the present disclosure.
FIG 4 is a schematic diagram showing components in a third operation of a method for fabricating a heterojunction cell according to an embodiment of the present disclosure.
FIG 5 is a schematic diagram showing components in a fourth operation of a method for fabricating a heterojunction cell according to an embodiment of the present disclosure.
FIG 6 is a schematic diagram showing components in a fifth operation of a method for fabricating a heterojunction cell according to an embodiment of the present disclosure.
FIG 7 is a schematic diagram showing components in a sixth operation of a method for fabricating a heterojunction cell according to an embodiment of the present disclosure.
FIG 8 is a schematic diagram showing components in a seventh operation of a method for fabricating a heterojunction cell according to an embodiment of the present disclosure.
FIG 9 is a schematic diagram showing components in an eighth operation of a method for fabricating a heterojunction cell according to an embodiment of the present disclosure.
FIG 10 is a schematic diagram showing components in a ninth operation of a method for fabricating a heterojunction cell according to an embodiment of the present disclosure.

Reference numerals:
100: heterojunction cell;
1: N-type single crystal silicon layer; 2: first intrinsic amorphous silicon passivation layer; 3: second intrinsic amorphous silicon passivation layer; 4: P-type amorphous silicon layer; 41: first P-type amorphous silicon layer; 42: second P-type amorphous silicon layer; 5: third intrinsic amorphous silicon passivation layer; 51: first spacer; 6: fourth intrinsic amorphous silicon passivation layer; 61: second spacer; 7: first N-type amorphous silicon layer; 8: second N-type amorphous silicon layer; 9: first transparent conductive layer; 10: second transparent conductive layer; 11: first metal grid line; 12: second metal grid line; 13: first mask; 14: second mask.

### DETAILED DESCRIPTION

Embodiments of the present disclosure are described in detail below, examples of which are illustrated in the drawings. The embodiments described herein with reference to drawings are explanatory, and used to generally understand the present disclosure. The embodiments shall not be construed to limit the present disclosure.

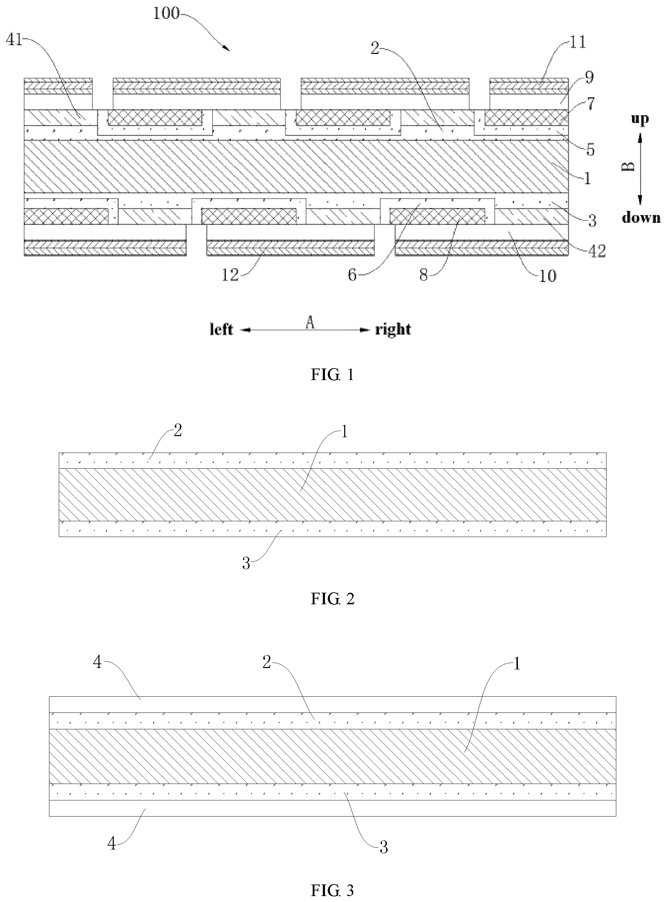

As shown in FIG 1 to FIG 10, the present invention provides a heterojunction cell and a method for fabricating a heterojunction cell.

In an embodiment of the present disclosure, the heterojunction cell 100 includes a N-type single crystal silicon layer 1, a first intrinsic amorphous silicon passivation layer 2, a first amorphous silicon layer and a plurality of first transparent conductive layers 9 deposited on a first surface of the N-type single crystal silicon layer 1, and a second intrinsic amorphous silicon passivation layer 3, a second amorphous silicon layer and a second transparent conductive layer 10 deposited on a second surface of the N-type single crystal silicon layer 1. As shown in FIG 1, the first surface is an upper surface of the N-type single crystal silicon layer 1, and the second surface is a lower surface of the N-type single crystal silicon layer 1.

The first amorphous silicon layer includes a first P-type amorphous silicon layer 41 and a first N-type amorphous silicon layer 7, and the second amorphous silicon layer includes a second P-type amorphous silicon layer 42 and a second N-type amorphous silicon layer 8. The second P-type amorphous silicon layer 42 and the N-type amorphous silicon layer 7 have the same quantity and are in one-to-one correspondence, and second N-type amorphous silicon layer 8 and the first P-type amorphous silicon layer 41 have the same quantity and are in one-to-one correspondence. There is a plurality of the first P-type amorphous silicon layers 41 and/or the first N-type amorphous silicon layers 7. The first P-type amorphous silicon layer(s) 41 and the first N-type amorphous silicon layer(s) 7 are interleaved at intervals in a longitudinal direction of the N-type single crystal silicon layer 1. As shown in FIG 1, the longitudinal direction of the N-type single crystal silicon layer 1 is a left and right direction.

A plurality of the first transparent conductive layers 9 exist and the first transparent conductive layers 9 are spaced apart from each other in the longitudinal direction of the N-type single crystal silicon layer 1, and configured to electrically connect any one of the first P-type amorphous silicon layers 41 to an adjacent first N-type amorphous silicon layer 7 at a first side. A plurality of the second transparent conductive layers 10 exist and the second transparent conductive layers 10 are spaced apart from each other in the longitudinal direction of the N-type single crystal silicon layer 1, and configured to electrically connect any one of the second N-type amorphous silicon layers 8 to an adjacent second P-type amorphous silicon layer 42 at a second side. An orientation of the first side is opposite to that of the second side. As shown in FIG 1, the first side is the right side, and the second side is the left side.

According to some embodiments of the present disclosure, in the heterojunction cell 100, the first P-type amorphous silicon layer 41 and the corresponding second N-type amorphous silicon layer 8 form a first cell segment with a certain voltage, and the first N-type amorphous silicon layer 7 and the corresponding second P-type amorphous silicon layer 42 form a second cell segment with a certain voltage. The first cell segment is connected to the second cell segment in series by the first transparent conductive layer 9 and the second transparent conductive layer 10. In this way, the heterojunction cell 100 in the present disclosure has a configuration of elements/segments connected in series inside the heterojunction cell, and has an increased open-circuit voltage and a decreased short-circuit current, and a photovoltaic module composed of the heterojunction cell(s) may be easily encapsulated and packaged. In addition, compared with the photovoltaic modules in the related art, in a same size, the photovoltaic module composed of the heterojunction cell 100 in the present disclosure need fewer connection points, resulting in a smaller resistance, and thus a less power loss caused by the resistance under a same illumination condition and a higher energy conversion efficiency.

It should be noted that in the present disclosure, materials of microcrystalline silicon and nanocrystalline silicon may be used. For example, the amorphous silicon layer as described above may be replaced by a microcrystalline silicon layer or a nanocrystalline silicon layer.

In order to facilitate understandings, an arrow A in FIG 1 shows a left and right direction (i.e., a direction from left to right or a direction from right to left) of the heterojunction cell 100 according to some embodiments of the present disclosure, and an arrow B in FIG 1 shows a up and down direction (i.e., a direction from up to down or a direction from down to up) of the heterojunction cell 100 according to some embodiments of the present disclosure.

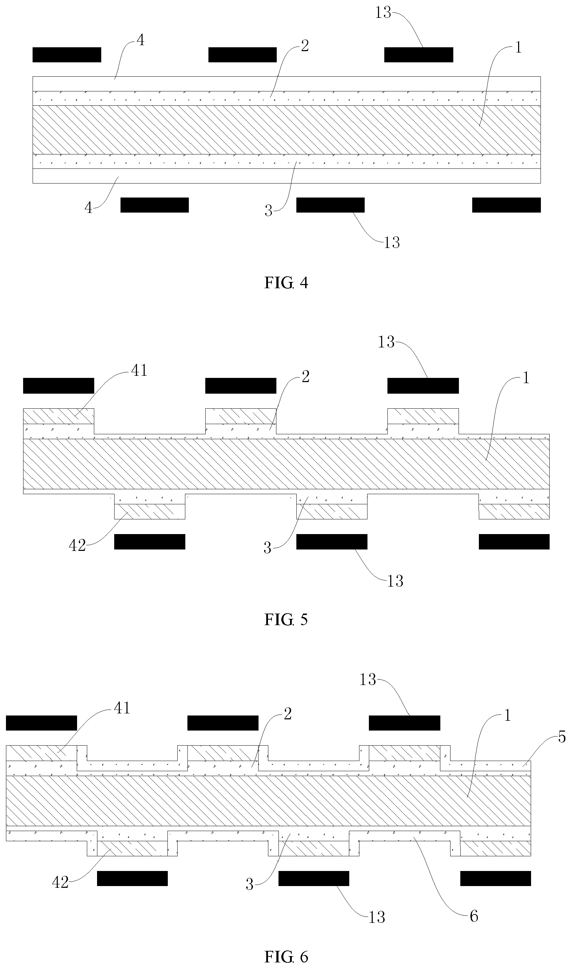

In the present invention, as shown in FIG 1, FIG 6 and FIG .7, the heterojunction cell 100 further includes a third intrinsic amorphous silicon passivation layer 5 deposited on a first surface of the first intrinsic amorphous silicon passivation layer 2, and a fourth intrinsic amorphous silicon passivation layer 6 deposited on a second surface of the second intrinsic amorphous silicon passivation layer 3. The third intrinsic amorphous silicon passivation layer 5 includes a first spacer 51 between the first P-type amorphous silicon layer 41 and the adjacent first N-type amorphous silicon layer 7 (i.e., the first N-type amorphous silicon layer 7 adjacent to the first P-type amorphous silicon layer 41), and the fourth intrinsic amorphous silicon passivation layer 6 includes a second spacer 61 between the second P-type amorphous silicon layer 42 and the adjacent second N-type amorphous silicon layer 8 (i.e., the second N-type amorphous silicon layer 8 adjacent to the second P-type amorphous silicon layer 42).

In this way, the first spacer 51 and the second spacer 61 may effectively prevent the first cell segment and the second cell segment from touching each other at the same pole, and improve the stable series connection of the inner elements of the heterojunction cell 100 according to some embodiments of the present disclosure, thereby improving the energy conversion efficiency.

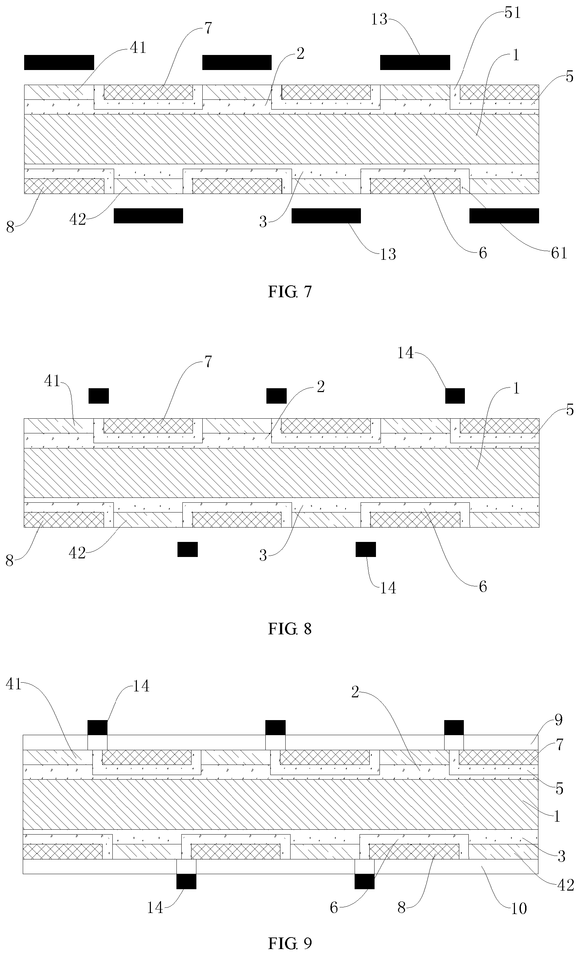

In some embodiments, as shown in FIG 6 and FIG 7, the third intrinsic amorphous silicon passivation layers 5 have an equal number to and are in one-to-one correspondence with the first P-type amorphous silicon layers 41. The number of the first P-type amorphous silicon layers 41 adjacent to one first N-type amorphous silicon layer 7 is equal to the number of the first spacers 51 on a respective third intrinsic amorphous silicon passivation layer 5. For example, one first N-type amorphous silicon layer 7 is deposited on one third intrinsic amorphous silicon passivation layer 5. There may be two first P-type amorphous silicon layers 41 adjacent to this first N-type amorphous silicon layer 7, and in this case, the respective third intrinsic amorphous silicon passivation layer 5 is provided with two first spacers 51. The fourth intrinsic amorphous silicon passivation layers 6 have an equal number to and are in one-to-one correspondence with the second P-type amorphous silicon layers 42. The number of the second P-type amorphous silicon layers 42 adjacent to one second N-type amorphous silicon layer 8 is equal to the number of the second spacers 61 on a respective fourth intrinsic amorphous silicon passivation layer 6. For example, one second N-type amorphous silicon layer 8 is deposited on one fourth intrinsic amorphous silicon passivation layer 6. There may be one second P-type amorphous silicon layer 42 adjacent to this second N-type amorphous silicon layer 8, and in this case, the respective fourth intrinsic amorphous silicon passivation layer 6 is provided with one second spacer 61.

As shown in FIG 7 to FIG 10, the third intrinsic amorphous silicon passivation layer 5 is at least partially disposed between the first intrinsic amorphous silicon passivation layer 2 and the first N-type amorphous silicon layer 7, and the fourth intrinsic amorphous silicon passivation layer 6 is at least partially disposed between the first intrinsic amorphous silicon passivation layer 3 and the first N-type amorphous silicon layer 8. In this way, the third intrinsic amorphous silicon passivation layer 5 and the fourth intrinsic amorphous silicon passivation layer 6 are not easy to fall off, such that the heterojunction cell 100 according to some embodiments of the present disclosure may be fabricated simply and conveniently.

In some embodiments, as shown in FIG 3, a first surface of the first P-type amorphous silicon layer 41, a first surface of the first N-type amorphous silicon layer 7 and a first surface of the first spacer 51 are coplanar, and a second surface of the second P-type amorphous silicon layer 42, a second surface of the second N-type amorphous silicon layer 8 and a second surface of the second spacer 61 are coplanar.

In this way, the first transparent conductive layer 9 and the second transparent conductive layer 10 may be deposited with uniform thickness, which may improve the stable series connection of the heterojunction cell 100 according to some embodiments of the present disclosure, thereby improving the energy conversion efficiency.

In some embodiments, the first P-type amorphous silicon layer 41 and the first N-type amorphous silicon layer 7 are arranged at equal intervals in the longitudinal direction of the N-type single crystal silicon layer 1, and the second P-type amorphous silicon layer 42 and the second N-type amorphous silicon layer 8 are arranged at equal intervals in the longitudinal direction of the N-type single crystal silicon layer 1. An interval between the first P-type amorphous silicon layer 41 and the first N-type amorphous silicon layer 7 is equal to that between the second P-type amorphous silicon layer 42 and the second N-type amorphous silicon layer 8.

In this way, the first cell segment and the second cell segment composed of the internal structure of the heterojunction cell 100 may be more regularly arranged in the left and right direction, and the number of the first cell segments and the number of the second cell segments may be flexibly adjusted. In addition, the first transparent conductive layer 9 and the second transparent conductive layer 10 configured to connect the first cell segment and the second cell segment have a same size in the left and right direction, and the heterojunction cell 100 may be fabricated simply and conveniently.

In some embodiments, as shown in FIG 1, the first P-type amorphous silicon layers 41 and the first N-type amorphous silicon layer 7 are presented in the same quantity, and this quantity is three. That is, the internal structure of the heterojunction cell 100 in the present disclosure has three first cell segments and three second cell segment interleaved at intervals in the left and right direction, which may be an equivalent to a structure of six slice cells connected in series, so as to achieve the effects of cutting a laminated module. On this basis, the heterojunction cell of the present disclosure does not need to be cut, and may be directly packaged to achieve the performances similar to the laminated module in the related art. In this way, the fabrication of the photovoltaic module of the heterojunction cells may be simplified to avoid the cutting process, and the damages on the transparent conductive layer caused by cutting the heterojunction cell can be avoided.

Furthermore, since the number of the first P-type amorphous silicon layers 41 is equal to the number of the first N-type amorphous silicon layers 7, a positive electrode and a negative electrode of the heterojunction cell 100 may be on a same side, thereby facilitating packaging.

In some embodiments, a first metal grid line 11 is disposed on a first surface of each of the first transparent conductive layers 9, and a second metal grid line 12 is disposed on a second surface of each of the second transparent conductive layers 10.

In some embodiments, the first transparent conductive layer 9 and the second transparent conductive layer 10 may be a transparent conductive layer with a moderate conductivity, such as an indium tin oxide (ITO) transparent conductive layer. In this case, the first metal grid line 11 and the second metal grid line 12 may constitute the electrodes of the heterojunction cell 100, and the first metal grid line 11 and the second metal grid line 12 are provided to reduce a connection resistance between the adjacent first and second cell segments, thereby improving the energy conversion efficiency of the heterojunction cell 100.

Alternatively, in some embodiments, the first transparent conductive layer 9 and the second transparent conductive layer 10 may be an Ag nanowire transparent conductive layer with a relatively high conductivity. In this way, the heterojunction cell 100 may have a high energy conversion efficiency, even if the first metal grid line 11 and the second metal grid line 12 are not provided.

As shown in FIG 2 to FIG 10, a first method for fabricating a heterojunction cell of the present disclosure includes operations as follows.

As shown in FIG 2, a first intrinsic amorphous silicon passivation layer 2 is deposited on a first surface of a N-type single crystal silicon layer 1, and a second intrinsic amorphous silicon passivation layer 3 is deposited on a second surface of the N-type single crystal silicon layer 1. The first intrinsic amorphous silicon passivation layer 2, the second intrinsic amorphous silicon passivation layer 3 and the N-type single crystal silicon layer 1 are aligned at both ends in the left and right direction.

As shown in FIG 3, a P-type amorphous silicon layer 4 is deposited on a first surface of the first intrinsic amorphous silicon passivation layer 2 and on a second surface of the second intrinsic amorphous silicon passivation layer 3, respectively. The two P-type amorphous silicon layers 4 and the N-type single crystal silicon layer 1 are aligned at both ends in the left and right direction.

As shown in FIG 4 and FIG 5, a first mask 13 is provided on the first surface and the second surface of the N-type single crystal silicon layer 1, respectively. The two P-type amorphous silicon layers 4 are etched to form a first P-type amorphous silicon layer 41 and a second P-type amorphous silicon layer 42, respectively.

As shown in FIG 6, a third intrinsic amorphous silicon passivation layer 5 is deposited at etching positions on the first surface of the first intrinsic amorphous silicon passivation layer 2 and a fourth intrinsic amorphous silicon passivation layer 6 is deposited at etching positions on the second surface of the second intrinsic amorphous silicon passivation layer 3.

As shown in FIG 7, the first N-type amorphous silicon layer 7 is deposited on a first surface of the third intrinsic amorphous silicon passivation layer 5, and the second N-type amorphous silicon layer 8 is deposited on a second surface of the fourth intrinsic amorphous silicon passivation layer 6. It is noted that a first spacer 51 is formed to space the first N-type amorphous silicon layer 7 and the adjacent first P-type amorphous silicon layer 41 apart from each other in the left and the right direction, and a second spacer 61 is be formed to space the second N-type amorphous silicon layer 8 and the adjacent second P-type amorphous silicon layer 42 apart from each other in the left and the right direction.

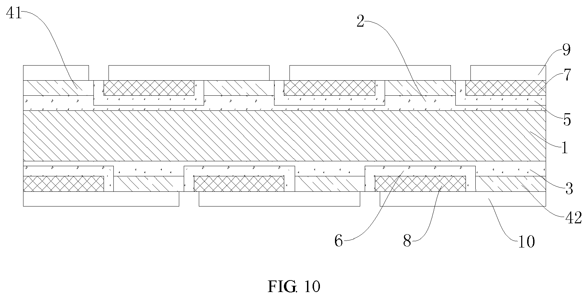

As shown in FIG 8 and FIG 9, the first mask 13 is removed, a second mask 14 is provided on the first surface and the second surface of the N-type single crystal silicon layer 1, respectively, and a first transparent conductive layer 9 is deposited on the first surface of the N-type single crystal silicon layer 1 and a second transparent conductive layer 10 is deposited on the second surface of the N-type single crystal silicon layer 1. By using the second masks 14, an integral layer of the first transparent conductive layer 9 is partially removed and a plurality of first transparent conductive layers 9 are formed to connect the first P-type amorphous silicon layer 41 and the corresponding first N-type amorphous silicon layer 7. Similarly, a plurality of second transparent conductive layers 10 are formed to connect the second P-type amorphous silicon layer 42 and the corresponding second N-type amorphous silicon layer 8, as shown in FIG 10. On this basis, there is no need to provide an additional cutting on the first transparent conductive layer 9 and the second transparent conductive layer 10, thereby improving efficiency of fabricating the heterojunction cell.

A first metal grid line 11 is printed or electroplated on a first surface of the first transparent conductive layer 9, and a second metal grid line 12 is printed or electroplated on a second surface of the second transparent conductive layer 10.

The heterojunction cell may be fabricated by the above-mentioned method in some embodiments of the present disclosure without cutting the first transparent conductive layer 9 and the second transparent conductive layer 10, which has a good power generation efficiency, and an internal structure equivalent to a structure of multiple cell slices connected in series, thereby improving the energy conversion efficiency.

In some embodiments, as shown in FIG 5 and FIG 6, in etching the P-type amorphous silicon layers 4, the first intrinsic amorphous silicon passivation layer 2 and the second intrinsic amorphous silicon passivation layer 3 are partially etched, to obtain a first groove with a depth greater than a thickness of the P-type amorphous silicon layer 4.

Further, in the subsequent depositing, the third intrinsic amorphous silicon passivation layer 5 and the fourth intrinsic amorphous silicon passivation layer 6 may be deposited as a layer having a shape providing a second groove with a depth equal to a thickness of the first P-type amorphous silicon layer 41 and the second P-type amorphous silicon layer 42, respectively, and the first N-type amorphous silicon layer 7 and the second N-type amorphous silicon layer 8 may be deposited I the second groove in such a manner that a thickness of the first N-type amorphous silicon layer 7 is equal to the thickness of the first P-type amorphous silicon layer 41, and a thickness of the second N-type amorphous silicon layer 8 is equal to the thickness of the second P-type amorphous silicon layer 42 (as shown in FIG 7). In addition, the depth of the first groove is larger than that of the second groove. The third intrinsic amorphous silicon passivation layer 5 and the fourth intrinsic amorphous silicon passivation layer 6 may be easily formed.

A second method for fabricating a heterojunction cell of the present invention includes operations as follows.

A first intrinsic amorphous silicon passivation layer 2 is deposited on a first surface of a N-type single crystal silicon layer 1, and a second intrinsic amorphous silicon passivation layer 3 is deposited on a second surface of the N-type single crystal silicon layer 1.

An N-type amorphous silicon layer is deposited on a first surface of the first intrinsic amorphous silicon passivation layer 2 and on a second surface of the second intrinsic amorphous silicon passivation layer 3, respectively.

A first mask 13 is provided on the first surface and the second surface of the N-type single crystal silicon layer 1, respectively. The two N-type amorphous silicon layers are etched to form a first N-type amorphous silicon layer 7 and a second N-type amorphous silicon layer 8, respectively.

A third intrinsic amorphous silicon passivation layer 5 is deposited at etching positions on the first surface of the first intrinsic amorphous silicon passivation layer 2, and a fourth intrinsic amorphous silicon passivation layer 6 is deposited at etching positions on the second surface of the second intrinsic amorphous silicon passivation layer 3.

A first P-type amorphous silicon layer 41 is deposited on a first surface of the third intrinsic amorphous silicon passivation layer 5, and a second P-type amorphous silicon layer 42 is deposited on a second surface of the fourth intrinsic amorphous silicon passivation layer 6.

The first masks 13 are removed. A second mask 14 is provided on the first surface and the second surface of the N-type single crystal silicon layer 1, and a first transparent conductive layer 9 is deposited on the first surface of the N-type single crystal silicon layer 1 and a second transparent conductive layer 10 is deposited on the second surface of the N-type single crystal silicon layer 1.

A first metal grid line 11 is formed on a first surface of the first transparent conductive layer 9, and a second metal grid line 12 is formed on a second surface of the second transparent conductive layer 10.

It should be noted that details and advantages of the first method for fabricating the heterojunction cell is also applicable to the second method for fabricating the heterojunction cell, which will not be elaborated here.

In the specification of the present disclosure, it is to be understood that terms such as "central", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", "circumferential" should be construed to refer to the orientation as then described or as shown in the drawings under discussion. These relative terms are for convenience of description and do not require that the present disclosure be constructed or operated in a particular orientation, and cannot be construed to limit the present disclosure.

In addition, terms such as "first" and "second" are used herein for purposes of description and are not intended to indicate or imply relative importance or significance or to imply the number of indicated technical features. Thus, the feature defined with "first" and "second" may comprise one or more of this feature. In the description of the present invention, "a plurality of" means two or more than two, unless specified otherwise.

In the specification of the present disclosure, unless specified or limited otherwise, the terms "mounted," "connected," "coupled," "fixed" and the like are used broadly, and may be, for example, fixed connections, detachable connections, or integral connections; may also be mechanical or electrical connections; may also be direct connections or indirect connections via intervening structures; may also be inner communications of two elements, which can be understood by those skilled in the art according to specific situations.

In the specification of the present disclosure, unless specified or limited otherwise, a structure in which a first feature is "above" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on," "above," or "on top of" a second feature may include an embodiment in which the first feature is right or obliquely "on," "above," or "on top of" the second feature, or just means that the first feature is at a height higher than that of the second feature; while a first feature "under," "below," or "on bottom of" a second feature may include an embodiment in which the first feature is right or obliquely "under," "below," or "on bottom of" the second feature, or just means that the first feature is at a height lower than that of the second feature.

Reference throughout this specification to "an embodiment," "some embodiments," "an example," "a specific example," or "some examples," means that a particular feature, structure, material, or characteristic described in connection with the embodiment or example is included in at least one embodiment or example of the present disclosure. Thus, the appearances of the phrases throughout this specification are not necessarily referring to the same embodiment or example of the present disclosure. Furthermore, the particular features, structures, materials, or characteristics may be combined in any suitable manner in one or more embodiments or examples. Furthermore, those skilled in the art may combine and conform the different embodiments or examples described in this specification, as well as the features of the different embodiments or examples, without conflicting each other.

Although explanatory embodiments have been shown and described, it would be appreciated by those skilled in the art that the above embodiments cannot be construed to limit the present disclosure.

## Claims

1. A heterojunction cell (100), comprising:
a N-type single crystal silicon layer (1);
a first intrinsic amorphous silicon passivation layer (2), a first amorphous silicon layer and a plurality of first transparent conductive layers (9) deposited on a first surface of the N-type single crystal silicon layer (1), successively; and
a second intrinsic amorphous silicon passivation layer (3), a second amorphous silicon layer and a plurality of second transparent conductive layers (10) deposited on a second surface of the N-type single crystal silicon layer (1), successively,
wherein the first amorphous silicon layer comprises first P-type amorphous silicon layers (41) and first N-type amorphous silicon layers (7), and the second amorphous silicon layer comprises second P-type amorphous silicon layers (42) in one-to-one correspondence with the first N-type amorphous silicon layers (7), and second N-type amorphous silicon layers (8) in one-to-one correspondence with the first P-type amorphous silicon layers (41);
wherein the first P-type amorphous silicon layers (41) and the first N-type amorphous silicon layers (7) are interleaved at intervals in a longitudinal direction of the N-type single crystal silicon layer (1),
wherein the plurality of the first transparent conductive layers (9) are spaced apart from each other in the longitudinal direction of the N-type single crystal silicon layer (1), and configured to electrically connect any one of the first P-type amorphous silicon layers (41) to an adjacent first N-type amorphous silicon layer (7) at a first side;
wherein the plurality of the second transparent conductive layers (10) are spaced apart from each other in the longitudinal direction of the N-type single crystal silicon layer (1), and configured to electrically connect any one of the second N-type amorphous silicon layers (8) to an adjacent second P-type amorphous silicon layer (42) at a second side;
wherein an orientation of the first side is opposite to that of the second side;and
third intrinsic amorphous silicon passivation layers (5), deposited on a first surface of the first intrinsic amorphous silicon passivation layer (2); and
fourth intrinsic amorphous silicon passivation layers (6), deposited on a second surface of the second intrinsic amorphous silicon passivation layer (3),
wherein each third intrinsic amorphous silicon passivation layer (5) comprises a first spacer (51) between one first P-type amorphous silicon layer (41) and a first N-type amorphous silicon layer (7) adjacent to the one first P-type amorphous silicon layer (41), and each fourth intrinsic amorphous silicon passivation layer (6) comprises a second spacer (61) between one second P-type amorphous silicon layer (42) and a second N-type amorphous silicon layer (8) adjacent to the second P-type amorphous silicon layer (42).

2. The heterojunction cell (100) according to claim 1, wherein the third intrinsic amorphous silicon passivation layers (5) are in one-to-one correspondence with the first N-type amorphous silicon layers (7) or the first P-type amorphous silicon layers (41); and
wherein the fourth intrinsic amorphous silicon passivation layers (6) are in one-to-one correspondence with the second N-type amorphous silicon layer (8) or the second P-type amorphous silicon layers (42).

3. The heterojunction cell (100) according to claim 2, wherein two first P-type amorphous silicon layers (41) are adjacent to one first N-type amorphous silicon layer (7), and a third intrinsic amorphous silicon passivation layer (5) corresponding to the one first N-type amorphous silicon layer (7) comprises two first spacers; and
wherein two second P-type amorphous silicon layers (42) are adjacent to one second N-type amorphous silicon layer (8), and a fourth intrinsic amorphous silicon passivation layer (6) corresponding to the second N-type amorphous silicon layer (8) comprises two spacers.

4. The heterojunction cell (100) according to any one of claims 1 to 3, wherein a first surface of the first P-type amorphous silicon layer (41), a first surface of the first N-type amorphous silicon layer (7) and a first surface of the first spacer (51) are coplanar, and a second surface of the second P-type amorphous silicon layer (42), a second surface of the second N-type amorphous silicon layer (8) and a second surface of the second spacer (61) are coplanar.

5. The heterojunction cell (100) according to any one of claims 1 to 4, wherein the N-type single crystal silicon layer (1), the first intrinsic amorphous silicon passivation layer (2) and the second intrinsic amorphous silicon passivation layer (3) and are aligned in the longitudinal direction of the N-type single crystal silicon layer (1).

6. The heterojunction cell (100) according to any one of claims 1 to 5, wherein the first P-type amorphous silicon layer (41) and the first N-type amorphous silicon layer (7) are arranged at equal intervals in the longitudinal direction of the N-type single crystal silicon layer (1), and the second P-type amorphous silicon layer (42) and the second N-type amorphous silicon layer (8) are arranged at equal intervals in the longitudinal direction of the N-type single crystal silicon layer (1).

7. The heterojunction cell (100) according to claim 6, wherein an interval between the first P-type amorphous silicon layer (41) and the first N-type amorphous silicon layer (7) is equal to that between the second P-type amorphous silicon layer (42) and the second N-type amorphous silicon layer (8).

8. The heterojunction cell (100) according to any one of claims 1 to 7, wherein the number of the first P-type amorphous silicon layers (41) is equal to the number of the first N-type amorphous silicon layers (7).

9. The heterojunction cell (100) according to any one of claims 1 to 8, wherein a first metal grid line (11) is disposed on a first surface of each of the first transparent conductive layers (9), and a second metal grid line (12) is disposed on a second surface of each of the second transparent conductive layers (10).

10. The heterojunction cell (100) according to any one of claims 1 to 9, wherein the first transparent conductive layers (9) and the second transparent conductive layers (10) are Ag nanowire transparent conductive layers.

11. A method for fabricating a heterojunction cell (100), comprising:
depositing a first intrinsic amorphous silicon passivation layer (2) on a first surface of a N-type single crystal silicon layer (1), and depositing a second intrinsic amorphous silicon passivation layer (3) on a second surface of the N-type single crystal silicon layer (1);
depositing a P-type amorphous silicon layer (4) on a first surface of the first intrinsic amorphous silicon passivation layer (2) and on a second surface of the second intrinsic amorphous silicon passivation layer (3);
providing a first mask (13) on the first surface and the second surface of the N-type single crystal silicon layer (1);
etching the P-type amorphous silicon layers (4) to form first P-type amorphous silicon layers (41) and second P-type amorphous silicon layers (42), respectively;
depositing third intrinsic amorphous silicon passivation layers (5) at etching positions on the first surface of the N-type single crystal silicon layer (1) and depositing fourth intrinsic amorphous silicon passivation layers (6) at etching positions on the second surface of the N-type single crystal silicon layer (1);
depositing first N-type amorphous silicon layers (7) on first surfaces of the third intrinsic amorphous silicon passivation layers (5), and depositing second N-type amorphous silicon layers (8) on second surfaces of the fourth intrinsic amorphous silicon passivation layers (6),
wherein the step of providing the first mask (13), the step of etching, and the step of depositing the first N-type amorphous silicon layers (7) and the second N-type amorphous silicon layers (8) are performed such that the second P-type amorphous silicon layers (42) are in one-to-one correspondence with the first N-type amorphous silicon layers (7), and the second N-type amorphous silicon layers (8) are in one-to-one correspondence with the first P-type amorphous silicon layers (41), and
wherein the step of depositing the third intrinsic amorphous silicon passivation layers (5) is performed such that spacers are provided between the first N-type amorphous silicon layers (7) and the first P-type amorphous silicon layers (41), the step of depositing fourth intrinsic amorphous silicon passivation layers (6) is performed such that spacers are provided between the second N-type amorphous silicon layers (8) and the second P-type amorphous silicon layers (42);
removing the first mask (13);
providing a second mask (14) on the first surface and the second surface of the N-type single crystal silicon layer (1);
depositing first transparent conductive layers (9) on the first surface of the N-type single crystal silicon layer (1) and depositing second transparent conductive layers (10) on the second surface of the N-type single crystal silicon layer (1),
wherein the step of providing the second mask (14) and the step of depositing the transparent conductive layers are performed such that the plurality of the first transparent conductive layers (9) are spaced apart from each other in the longitudinal direction of the N-type single crystal silicon layer (1), and configured to electrically connect any one of the first P-type amorphous silicon layers (41) to an adjacent first N-type amorphous silicon layer (7) at a first side, and such that the plurality of the second transparent conductive layers (10) are spaced apart from each other in the longitudinal direction of the N-type single crystal silicon layer (1), and configured to electrically connect any one of the second N-type amorphous silicon layers (8) to an adjacent second P-type amorphous silicon layer (42) at a second side opposite to the first side; and
forming a first metal grid line (11) on a first surface of the plurality of first transparent conductive layers (9), and forming a second metal grid line (12) on a second surface of the plurality of second transparent conductive layers (10).

12. The method according to claim 11, wherein when the P-type amorphous silicon layers are etched, the first intrinsic amorphous silicon passivation layer (2) and the second intrinsic amorphous silicon passivation layer (3) are etched to obtain a first groove with a depth greater than a thickness of the P-type amorphous silicon layer.

13. The method according to claim 11 or 12, wherein the first metal grid line (11) is printed or electroplated on the first surface of the plurality of first transparent conductive layers (9), and the second metal grid line (12) is printed or electroplated on the second surface of the plurality of second transparent conductive layers (10).

14. A method for fabricating a heterojunction cell (100), comprising:
depositing a first intrinsic amorphous silicon passivation layer (2) on a first surface of a N-type single crystal silicon layer (1), and depositing a second intrinsic amorphous silicon passivation layer (3) on a second surface of the N-type single crystal silicon layer (1);
depositing a N-type amorphous silicon layer on a first surface of the first intrinsic amorphous silicon passivation layer (2) and on a second surface of the second intrinsic amorphous silicon passivation layer (3);
providing a first mask (13) on the first surface and the second surface of the N-type single crystal silicon layer (1);
etching the N-type amorphous silicon layers to form first N-type amorphous silicon layers (7) and second N-type amorphous silicon layers (8), respectively;
depositing third intrinsic amorphous silicon passivation layers (5) at etching positions on the first surface of the N-type single crystal silicon layer (1) and depositing fourth intrinsic amorphous silicon passivation layers (6) at etching positions on the second surface of the N-type single crystal silicon layer (1);
depositing first P-type amorphous silicon layer (41)s on first surfaces of the third intrinsic amorphous silicon passivation layers (5), and depositing second P-type amorphous silicon layers (42) on second surfaces of the fourth intrinsic amorphous silicon passivation layers (6),
wherein the step of providing the first mask (13), the step of etching, and the step of depositing the first P-type amorphous silicon layers (41) and the second P-type amorphous silicon layers (42) are performed such that the second P-type amorphous silicon layers (42) are in one-to-one correspondence with the first N-type amorphous silicon layers (7), and the second N-type amorphous silicon layers (8) are in one-to-one correspondence with the first P-type amorphous silicon layers (41), and
wherein the step of depositing the third intrinsic amorphous silicon passivation layers (5) is performed such that spacers are provided between the first N-type amorphous silicon layers (7) and the first P-type amorphous silicon layers (41), the step of depositing fourth intrinsic amorphous silicon passivation layers (6) is performed such that spacers are provided between the second N-type amorphous silicon layers (8) and the second P-type amorphous silicon layers (42);
removing the first mask (13);
providing a second mask (14) on the first surface and the second surface of the N-type single crystal silicon layer (1);
depositing a plurality of first transparent conductive layers (9) on the first surface of the N-type single crystal silicon layer (1) and depositing a plurality of second transparent conductive layers (10) on the second surface of the N-type single crystal silicon layer (1),
wherein the step of providing the second mask (14) and the step of depositing the transparent conductive layers are performed such that the plurality of the first transparent conductive layers (9) are spaced apart from each other in the longitudinal direction of the N-type single crystal silicon layer (1), and configured to electrically connect any one of the first P-type amorphous silicon layers (41) to an adjacent first N-type amorphous silicon layer (7) at a first side, and such that the plurality of the second transparent conductive layers (10) are spaced apart from each other in the longitudinal direction of the N-type single crystal silicon layer (1), and configured to electrically connect any one of the second N-type amorphous silicon layers (8) to an adjacent second P-type amorphous silicon layer (42) at a second side opposite to the first side; and
forming a first metal grid line (11) on a first surface of the plurality of first transparent conductive layers (9), and forming a second metal grid line (12) on a second surface of the plurality of second transparent conductive layers (10).

## Patentansprüche

1. Heteroübergangszelle (100), umfassend:
eine N-Typ-Einkristallsiliziumschicht (1);
eine erste intrinsische amorphe Siliziumpassivierungsschicht (2), eine erste amorphe Siliziumschicht und eine Vielzahl von ersten transparenten leitfähigen Schichten (9), die nacheinander auf einer ersten Oberfläche der N-Typ-Einkristallsiliziumschicht (1) abgeschieden sind; und
eine zweite intrinsische amorphe Siliziumpassivierungsschicht (3), eine zweite amorphe Siliziumschicht und eine Vielzahl von zweiten transparenten leitfähigen Schichten (10), die nacheinander auf einer zweiten Oberfläche der N-Typ-Einkristallsiliziumschicht (1) abgeschieden sind,
wobei die erste amorphe Siliziumschicht erste P-Typ-amorphe Siliziumschichten (41) und erste N-Typ-amorphe Siliziumschichten (7) umfasst, und die zweite amorphe Siliziumschicht zweite P-Typ-amorphe Siliziumschichten (42) in Eins-zu-Eins-Entsprechung mit den ersten N-Typ-amorphen Siliziumschichten (7) und zweite N-Typ-amorphe Siliziumschichten (8) in Eins-zu-Eins-Entsprechung mit den ersten P-Typ-amorphen Siliziumschichten (41) umfasst;
wobei die ersten P-Typ-amorphen Siliziumschichten (41) und die ersten N-Typ-amorphen Siliziumschichten (7) in einer Längsrichtung der N-Typ-Einkristallsiliziumschicht (1) in Abständen verschachtelt sind,
wobei die Vielzahl der ersten transparenten leitfähigen Schichten (9) in der Längsrichtung der N-Typ-Einkristallsiliziumschicht (1) voneinander beabstandet ist und konfiguriert ist, um eine beliebige der ersten P-Typ-amorphen Siliziumschichten (41) mit einer benachbarten ersten N-Typ-amorphen Siliziumschicht (7) an einer ersten Seite elektrisch zu verbinden;
wobei die Vielzahl der zweiten transparenten leitfähigen Schichten (10) in der Längsrichtung der N-Typ-Einkristallsiliziumschicht (1) voneinander beabstandet ist und konfiguriert ist, um eine beliebige der zweiten N-Typ-amorphen Siliziumschichten (8) mit einer benachbarten zweiten P-Typ-amorphen Siliziumschicht (42) an einer zweiten Seite elektrisch zu verbinden;
wobei eine Ausrichtung der ersten Seite derjenigen der zweiten Seite entgegengesetzt ist; und
dritte intrinsische amorphe Siliziumpassivierungsschichten (5), abgeschieden auf einer ersten Oberfläche der ersten intrinsischen amorphen Siliziumpassivierungsschicht (2); und
vierte intrinsische amorphe Siliziumpassivierungsschichten (6), abgeschieden auf einer zweiten Oberfläche der zweiten intrinsischen amorphen Siliziumpassivierungsschicht (3),
wobei jede dritte intrinsische amorphe Siliziumpassivierungsschicht (5) einen ersten Abstandshalter (51) zwischen einer ersten P-Typ-amorphen Siliziumschicht (41) und einer ersten N-Typ-amorphen Siliziumschicht (7), die der einen ersten P-Typ-amorphen Siliziumschicht (41) benachbart ist, umfasst, und jede vierte intrinsische amorphe Siliziumpassivierungsschicht (6) einen zweiten Abstandshalter (61) zwischen einer zweiten P-Typ-amorphen Siliziumschicht (42) und einer zweiten N-Typ-amorphen Siliziumschicht (8), die der zweiten P-Typ-amorphen Siliziumschicht (42) benachbart ist, umfasst.

2. Heteroübergangszelle (100) nach Anspruch 1, wobei die dritten intrinsischen amorphen Siliziumpassivierungsschichten (5) in einer Eins-zu-Eins-Entsprechung mit den ersten N-Typ-amorphen Siliziumschichten (7) oder den ersten P-Typ-amorphen Siliziumschichten (41) stehen; und
wobei die vierten intrinsischen amorphen Siliziumpassivierungsschichten (6) in Eins-zu-Eins-Entsprechung mit der zweiten N-Typ-amorphen Siliziumschicht (8) oder den zweiten P-Typ-amorphen Siliziumschichten (42) stehen.

3. Heteroübergangszelle (100) nach Anspruch 2, wobei zwei erste P-Typ-amorphe Siliziumschichten (41) an eine erste N-Typ-amorphe Siliziumschicht (7) angrenzen, und eine dritte intrinsische amorphe Siliziumpassivierungsschicht (5), die der einen ersten N-Typ-amorphen Siliziumschicht (7) entspricht, zwei erste Abstandshalter umfasst; und
wobei zwei zweite P-Typ-amorphe Siliziumschichten (42) an eine zweite N-Typ-amorphe Siliziumschicht (8) angrenzen und eine vierte intrinsische amorphe Siliziumpassivierungsschicht (6), die der zweiten N-Typ-amorphen Siliziumschicht (8) entspricht, zwei Abstandshalter umfasst.

4. Heteroübergangszelle (100) nach einem der Ansprüche 1 bis 3, wobei eine erste Oberfläche der ersten P-Typ-amorphen Siliziumschicht (41), eine erste Oberfläche der ersten N-Typ-amorphen Siliziumschicht (7) und eine erste Oberfläche des ersten Abstandshalters (51) koplanar sind, und eine zweite Oberfläche der zweiten P-Typ-amorphen Siliziumschicht (42), eine zweite Oberfläche der zweiten N-Typ-amorphen Siliziumschicht (8) und eine zweite Oberfläche des zweiten Abstandshalters (61) koplanar sind.

5. Heteroübergangszelle (100) nach einem der Ansprüche 1 bis 4, wobei die N-Typ-Einkristallsiliziumschicht (1), die erste intrinsische amorphe Siliziumpassivierungsschicht (2) und die zweite intrinsische amorphe Siliziumpassivierungsschicht (3) in der Längsrichtung der N-Typ-Einkristallsiliziumschicht (1) ausgerichtet sind.

6. Heteroübergangszelle (100) nach einem der Ansprüche 1 bis 5, wobei die erste P-Typ-amorphe Siliziumschicht (41) und die erste N-Typ-amorphe Siliziumschicht (7) in gleichen Abständen in der Längsrichtung der N-Typ-Einkristallsiliziumschicht (1) angeordnet sind und die zweite P-Typ-amorphe Siliziumschicht (42) und die zweite N-Typ-amorphe Siliziumschicht (8) in gleichen Abständen in der Längsrichtung der N-Typ-Einkristallsiliziumschicht (1) angeordnet sind.

7. Heteroübergangszelle (100) nach Anspruch 6, wobei ein Abstand zwischen der ersten P-Typ-amorphen Siliziumschicht (41) und der ersten N-Typ-amorphen Siliziumschicht (7) gleich dem zwischen der zweiten P-Typ-amorphen Siliziumschicht (42) und der zweiten N-Typ-amorphen Siliziumschicht (8) ist.

8. Heteroübergangszelle (100) nach einem der Ansprüche 1 bis 7, wobei die Anzahl der ersten P-Typ-amorphen Siliziumschichten (41) gleich der Anzahl der ersten N-Typ-amorphen Siliziumschichten (7) ist.

9. Heteroübergangszelle (100) nach einem der Ansprüche 1 bis 8, wobei eine erste Metallgitterlinie (11) auf einer ersten Oberfläche jeder der ersten transparenten leitfähigen Schichten (9) angeordnet ist und eine zweite Metallgitterlinie (12) auf einer zweiten Oberfläche jeder der zweiten transparenten leitfähigen Schichten (10) angeordnet ist.

10. Heteroübergangszelle (100) nach einem der Ansprüche 1 bis 9, wobei die ersten transparenten leitfähigen Schichten (9) und die zweiten transparenten leitfähigen Schichten (10) transparente leitfähige Ag-Nanodraht-Schichten sind.

11. Verfahren zum Herstellen einer Heteroübergangszelle (100), umfassend:
Abscheiden einer ersten intrinsischen amorphen Siliziumpassivierungsschicht (2) auf einer ersten Oberfläche einer N-Typ-Einkristallsiliziumschicht (1), und Abscheiden einer zweiten intrinsischen amorphen Siliziumpassivierungsschicht (3) auf einer zweiten Oberfläche der N-Typ-Einkristallsiliziumschicht (1);
Abscheiden einer P-Typ-amorphen Siliziumschicht (4) auf einer ersten Oberfläche der ersten intrinsischen amorphen Siliziumpassivierungsschicht (2) und auf einer zweiten Oberfläche der zweiten intrinsischen amorphen Siliziumpassivierungsschicht (3);
Bereitstellen einer ersten Maske (13) auf der ersten Oberfläche und der zweiten Oberfläche der N-Typ-Einkristallsiliziumschicht (1);
Ätzen der P-Typ-amorphen Siliziumschichten (4), um erste P-Typ-amorphe Siliziumschichten (41) beziehungsweise zweite P-Typ-amorphe Siliziumschichten (42) zu bilden;
Abscheiden von dritten intrinsischen amorphen Siliziumpassivierungsschichten (5) an Ätzpositionen auf der ersten Oberfläche der N-Typ-Einkristallsiliziumschicht (1) und Abscheiden von vierten intrinsischen amorphen Siliziumpassivierungsschichten (6) an Ätzpositionen auf der zweiten Oberfläche der N-Typ-Einkristallsiliziumschicht (1);
Abscheiden erster N-Typ-amorpher Siliziumschichten (7) auf ersten Oberflächen der dritten intrinsischen amorphen Siliziumpassivierungsschichten (5) und Abscheiden zweiter N-Typ-amorpher Siliziumschichten (8) auf zweiten Oberflächen der vierten intrinsischen amorphen Siliziumpassivierungsschichten (6),
wobei der Schritt des Bereitstellens der ersten Maske (13), der Schritt des Ätzens und der Schritt des Abscheidens der ersten N-Typ-amorphen Siliziumschichten (7) und der zweiten N-Typ-amorphen Siliziumschichten (8) derart durchgeführt werden, dass die zweiten P-Typ-amorphen Siliziumschichten (42) in einer Eins-zu-Eins-Entsprechung mit den ersten N-Typ-amorphen Siliziumschichten (7) stehen und die zweiten N-Typ-amorphen Siliziumschichten (8) in einer Eins-zu-Eins-Entsprechung mit den ersten P-Typ-amorphen Siliziumschichten (41) stehen, und
wobei der Schritt des Abscheidens der dritten intrinsischen amorphen Siliziumpassivierungsschichten (5) derart durchgeführt wird, dass Abstandshalter zwischen den ersten N-Typ-amorphen Siliziumschichten (7) und den ersten P-Typ-amorphen Siliziumschichten (41) bereitgestellt werden, der Schritt des Abscheidens vierter intrinsischer amorpher Siliziumpassivierungsschichten (6) so durchgeführt wird, dass Abstandshalter zwischen den zweiten N-Typ-amorphen Siliziumschichten (8) und den zweiten P-Typ-amorphen Siliziumschichten (42) bereitgestellt werden;
Entfernen der ersten Maske (13);
Bereitstellen einer zweiten Maske (14) auf der ersten Oberfläche und der zweiten Oberfläche der N-Typ-Einkristallsiliziumschicht (1);
Abscheiden erster transparenter leitfähiger Schichten (9) auf der ersten Oberfläche der N-Typ-Einkristallsiliziumschicht (1) und Abscheiden zweiter transparenter leitfähiger Schichten (10) auf der zweiten Oberfläche der N-Typ-Einkristallsiliziumschicht (1),
wobei der Schritt des Bereitstellens der zweiten Maske (14) und der Schritt des Abscheidens der transparenten leitfähigen Schichten derart durchgeführt werden, dass die Vielzahl der ersten transparenten leitfähigen Schichten (9) in der Längsrichtung der N-Typ-Einkristallsiliziumschicht (1) voneinander beabstandet sind und konfiguriert sind, um eine beliebige der ersten P-Typ-amorphen Siliziumschichten (41) mit einer benachbarten ersten N-Typ-amorphen Siliziumschicht (7) an einer ersten Seite elektrisch zu verbinden, und derart, dass die Vielzahl der zweiten transparenten leitfähigen Schichten (10) in der Längsrichtung der N-Typ-Einkristallsiliziumschicht (1) voneinander beabstandet sind und konfiguriert sind, um eine beliebige der zweiten N-Typ-amorphen Siliziumschichten (8) mit einer benachbarten zweiten P-Typ-amorphen Siliziumschicht (42) an einer zweiten Seite, die der ersten Seite gegenüber liegt, elektrisch zu verbinden; und
Bilden einer ersten Metallgitterlinie (11) auf einer ersten Oberfläche der Vielzahl von ersten transparenten leitfähigen Schichten (9), und Bilden einer zweiten Metallgitterlinie (12) auf einer zweiten Oberfläche der Vielzahl von zweiten transparenten leitfähigen Schichten (10).

12. Verfahren nach Anspruch 11, wobei, wenn die P-Typ-amorphen Siliziumschichten geätzt werden, die erste intrinsische amorphe Siliziumpassivierungsschicht (2) und die zweite intrinsische amorphe Siliziumpassivierungsschicht (3) geätzt werden, um eine erste Furche mit einer Tiefe zu erhalten, die größer als eine Dicke der P-Typ-amorphen Siliziumschicht ist.

13. Verfahren nach Anspruch 11 oder 12, wobei die erste Metallgitterlinie (11) auf die erste Oberfläche der Vielzahl von ersten transparenten leitfähigen Schichten (9) gedruckt oder galvanisiert ist und die zweite Metallgitterlinie (12) auf die zweite Oberfläche der Vielzahl von zweiten transparenten leitfähigen Schichten (10) gedruckt oder galvanisiert ist.

14. Verfahren zum Herstellen einer Heteroübergangszelle (100), umfassend:
Abscheiden einer ersten intrinsischen amorphen Siliziumpassivierungsschicht (2) auf einer ersten Oberfläche einer N-Typ-Einkristallsiliziumschicht (1), und Abscheiden einer zweiten intrinsischen amorphen Siliziumpassivierungsschicht (3) auf einer zweiten Oberfläche der N-Typ-Einkristallsiliziumschicht (1);
Abscheiden einer N-Typ-amorphen Siliziumschicht auf einer ersten Oberfläche der ersten intrinsischen amorphen Siliziumpassivierungsschicht (2) und auf einer zweiten Oberfläche der zweiten intrinsischen amorphen Siliziumpassivierungsschicht (3);
Bereitstellen einer ersten Maske (13) auf der ersten Oberfläche und der zweiten Oberfläche der N-Typ-Einkristallsiliziumschicht (1);
Ätzen der N-Typ-amorphen Siliziumschichten, um erste N-Typ-amorphe Siliziumschichten (7) bzw. zweite N-Typ-amorphe Siliziumschichten (8) zu bilden;
Abscheiden von dritten intrinsischen amorphen Siliziumpassivierungsschichten (5) an Ätzpositionen auf der ersten Oberfläche der N-Typ-Einkristallsiliziumschicht (1) und Abscheiden von vierten intrinsischen amorphen Siliziumpassivierungsschichten (6) an Ätzpositionen auf der zweiten Oberfläche der N-Typ-Einkristallsiliziumschicht (1);
Abscheiden erster amorpher P-Typ-Siliziumschichten (41) auf ersten Oberflächen der dritten intrinsischen amorphen Siliziumpassivierungsschichten (5) und Abscheiden zweiter amorpher P-Typ-Siliziumschichten (42) auf zweiten Oberflächen der vierten intrinsischen amorphen Siliziumpassivierungsschichten (6),
wobei der Schritt des Bereitstellens der ersten Maske (13), der Schritt des Ätzens und der Schritt des Abscheidens der ersten P-Typ-amorphen Siliziumschichten (41) und der zweiten P-Typ-amorphen Siliziumschichten (42) derart durchgeführt werden, dass die zweiten P-Typ-amorphen Siliziumschichten (42) in einer Eins-zu-Eins-Entsprechung mit den ersten N-Typ-amorphen Siliziumschichten (7) stehen und die zweiten N-Typ-amorphen Siliziumschichten (8) in einer Eins-zu-Eins-Entsprechung mit den ersten P-Typ-amorphen Siliziumschichten (41) stehen, und
wobei der Schritt des Abscheidens der dritten intrinsischen amorphen Siliziumpassivierungsschichten (5) derart durchgeführt wird, dass Abstandshalter zwischen den ersten N-Typ-amorphen Siliziumschichten (7) und den ersten P-Typ-amorphen Siliziumschichten (41) bereitgestellt werden, der Schritt des Abscheidens vierter intrinsischer amorpher Siliziumpassivierungsschichten (6) so durchgeführt wird, dass Abstandshalter zwischen den zweiten N-Typ-amorphen Siliziumschichten (8) und den zweiten P-Typ-amorphen Siliziumschichten (42) bereitgestellt werden;
Entfernen der ersten Maske (13);
Bereitstellen einer zweiten Maske (14) auf der ersten Oberfläche und der zweiten Oberfläche der N-Typ-Einkristallsiliziumschicht (1);
Abscheiden einer Vielzahl von ersten transparenten leitfähigen Schichten (9) auf der ersten Oberfläche der N-Typ-Einkristallsiliziumschicht (1) und Abscheiden einer Vielzahl von zweiten transparenten leitfähigen Schichten (10) auf der zweiten Oberfläche der N-Typ-Einkristallsiliziumschicht (1),
wobei der Schritt des Bereitstellens der zweiten Maske (14) und der Schritt des Abscheidens der transparenten leitfähigen Schichten derart durchgeführt werden, dass die Vielzahl der ersten transparenten leitfähigen Schichten (9) in der Längsrichtung der N-Typ-Einkristallsiliziumschicht (1) voneinander beabstandet sind und konfiguriert sind, um eine beliebige der ersten P-Typ-amorphen Siliziumschichten (41) mit einer benachbarten ersten N-Typ-amorphen Siliziumschicht (7) an einer ersten Seite elektrisch zu verbinden, und derart, dass die Vielzahl der zweiten transparenten leitfähigen Schichten (10) in der Längsrichtung der N-Typ-Einkristallsiliziumschicht (1) voneinander beabstandet sind und konfiguriert sind, um eine beliebige der zweiten N-Typ-amorphen Siliziumschichten (8) mit einer benachbarten zweiten P-Typ-amorphen Siliziumschicht (42) an einer zweiten Seite, die der ersten Seite gegenüber liegt, elektrisch zu verbinden; und
Bilden einer ersten Metallgitterlinie (11) auf einer ersten Oberfläche der Vielzahl von ersten transparenten leitfähigen Schichten (9), und Bilden einer zweiten Metallgitterlinie (12) auf einer zweiten Oberfläche der Vielzahl von zweiten transparenten leitfähigen Schichten (10).

## Revendications

1. Cellule à hétérojonction (100), comprenant :
une couche de silicium monocristallin de type N (1) ;
une première couche de passivation en silicium amorphe intrinsèque (2), une première couche de silicium amorphe et une pluralité de premières couches conductrices transparentes (9) déposées sur une première surface de la couche de silicium monocristallin de type N (1), successivement ; et
une deuxième couche de passivation en silicium amorphe intrinsèque (3), une seconde couche de silicium amorphe et une pluralité de secondes couches conductrices transparentes (10) déposées sur une seconde surface de la couche de silicium monocristallin de type N (1), successivement,
dans laquelle la première couche de silicium amorphe comprend des premières couches de silicium amorphe de type P (41) et des premières couches de silicium amorphe de type N (7), et la seconde couche de silicium amorphe comprend des secondes couches de silicium amorphe de type P (42) en correspondance univoque avec les premières couches de silicium amorphe de type N (7), et des secondes couches de silicium amorphe de type N (8) en correspondance univoque avec les premières couches de silicium amorphe de type P (41) ;
dans laquelle les premières couches de silicium amorphe de type P (41) et les premières couches de silicium amorphe de type N (7) sont entrelacées à des intervalles dans une direction longitudinale de la couche de silicium monocristallin de type N (1),
dans laquelle la pluralité des premières couches conductrices transparentes (9) sont espacées les unes des autres dans la direction longitudinale de la couche de silicium monocristallin de type N (1), et configurées pour connecter électriquement l'une quelconque des premières couches de silicium amorphe de type P (41) à une première couche de silicium amorphe de type N (7) adjacente au niveau d'un premier côté ;
dans laquelle la pluralité des secondes couches conductrices transparentes (10) sont espacées les unes des autres dans la direction longitudinale de la couche de silicium monocristallin de type N (1), et configurées pour connecter électriquement l'une quelconque des secondes couches de silicium amorphe de type N (8) à une seconde couche de silicium amorphe de type P (42) adjacente au niveau d'un second côté ;
dans laquelle une orientation du premier côté est opposée à celle du second côté ;et
des troisièmes couches de passivation en silicium amorphe intrinsèque (5), déposées sur une première surface de la première couche de passivation en silicium amorphe intrinsèque (2) ; et
des quatrièmes couches de passivation en silicium amorphe intrinsèque (6), déposées sur une seconde surface de la deuxième couche de passivation en silicium amorphe intrinsèque (3),
dans laquelle chaque troisième couche de passivation en silicium amorphe intrinsèque (5) comprend un premier espaceur (51) entre une première couche de silicium amorphe de type P (41) et une première couche de silicium amorphe de type N (7) adjacente à la première couche de silicium amorphe de type P (41) précitée, et chaque quatrième couche de passivation en silicium amorphe intrinsèque (6) comprend un second espaceur (61) entre une seconde couche de silicium amorphe de type P (42) et une seconde couche de silicium amorphe de type N (8) adjacente à la seconde couche de silicium amorphe de type P (42).

2. Cellule à hétérojonction (100) selon la revendication 1, dans laquelle les troisièmes couches de passivation en silicium amorphe intrinsèque (5) sont en correspondance univoque avec les premières couches de silicium amorphe de type N (7) ou les premières couches de silicium amorphe de type P (41) ; et
dans laquelle les quatrièmes couches de passivation en silicium amorphe intrinsèque (6) sont en correspondance univoque avec la seconde couche de silicium amorphe de type N (8) ou les secondes couches de silicium amorphe de type P (42).

3. Cellule à hétérojonction (100) selon la revendication 2, dans laquelle deux premières couches de silicium amorphe de type P (41) sont adjacentes à une première couche de silicium amorphe de type N (7), et une troisième couche de passivation en silicium amorphe intrinsèque (5) correspondant à la première couche de silicium amorphe de type N (7) précitée comprend deux premiers espaceurs ; et
dans laquelle deux secondes couches de silicium amorphe de type P (42) sont adjacentes à une seconde couche de silicium amorphe de type N (8), et une quatrième couche de passivation en silicium amorphe intrinsèque (6) correspondant à la seconde couche de silicium amorphe de type N (8) comprend deux espaceurs.

4. Cellule à hétérojonction (100) selon l'une quelconque des revendications 1 à 3, dans laquelle une première surface de la première couche de silicium amorphe de type P (41), une première surface de la première couche de silicium amorphe de type N (7) et une première surface du premier espaceur (51) sont coplanaires, et une seconde surface de la seconde couche de silicium amorphe de type P (42), une seconde surface de la seconde couche de silicium amorphe de type N (8) et une seconde surface du second espaceur (61) sont coplanaires.

5. Cellule à hétérojonction (100) selon l'une quelconque des revendications 1 à 4, dans laquelle la couche de silicium monocristallin de type N (1), la première couche de passivation en silicium amorphe intrinsèque (2) et la deuxième couche de passivation en silicium amorphe intrinsèque (3) sont alignées dans la direction longitudinale de la couche de silicium monocristallin de type N (1).

6. Cellule à hétérojonction (100) selon l'une quelconque des revendications 1 à 5, dans laquelle la première couche de silicium amorphe de type P (41) et la première couche de silicium amorphe de type N (7) sont agencées à intervalles égaux dans la direction longitudinale de la couche de silicium monocristallin de type N (1), et la seconde couche de silicium amorphe de type P (42) et la seconde couche de silicium amorphe de type N (8) sont agencées à intervalles égaux dans la direction longitudinale de la couche de silicium monocristallin de type N (1).

7. Cellule à hétérojonction (100) selon la revendication 6, dans laquelle un intervalle entre la première couche de silicium amorphe de type P (41) et la première couche de silicium amorphe de type N (7) est égal à celui entre la seconde couche de silicium amorphe de type P (42) et la seconde couche de silicium amorphe de type N (8).

8. Cellule à hétérojonction (100) selon l'une quelconque des revendications 1 à 7, dans laquelle le nombre des premières couches de silicium amorphe de type P (41) est égal au nombre des premières couches de silicium amorphe de type N (7).

9. Cellule à hétérojonction (100) selon l'une quelconque des revendications 1 à 8, dans laquelle une première ligne de grille métallique (11) est disposée sur une première surface de chacune des premières couches conductrices transparentes (9), et une seconde ligne de grille métallique (12) est disposée sur une seconde surface de chacune des secondes couches conductrices transparentes (10).

10. Cellule à hétérojonction (100) selon l'une quelconque des revendications 1 à 9, dans laquelle les premières couches conductrices transparentes (9) et les secondes couches conductrices transparentes (10) sont des couches conductrices transparentes à nanofil d'Ag.

11. Procédé permettant de fabriquer une cellule à hétérojonction (100), comprenant :
le dépôt d'une première couche de passivation en silicium amorphe intrinsèque (2) sur une première surface d'une couche de silicium monocristallin de type N (1), et le dépôt d'une deuxième couche de passivation en silicium amorphe intrinsèque (3) sur une seconde surface de la couche de silicium monocristallin de type N (1) ;
le dépôt d'une couche de silicium amorphe de type P (4) sur une première surface de la première couche de passivation en silicium amorphe intrinsèque (2) et sur une seconde surface de la deuxième couche de passivation en silicium amorphe intrinsèque (3) ;
la fourniture d'un premier masque (13) sur la première surface et la seconde surface de la couche de silicium monocristallin de type N (1) ;
la gravure des couches de silicium amorphe de type P (4) pour former des premières couches de silicium amorphe de type P (41) et des secondes couches de silicium amorphe de type P (42), respectivement ;
le dépôt de troisièmes couches de passivation en silicium amorphe intrinsèque (5) au niveau de positions de gravure sur la première surface de la couche de silicium monocristallin de type N (1) et le dépôt de quatrièmes couches de passivation en silicium amorphe intrinsèque (6) au niveau de positions de gravure sur la seconde surface de la couche de silicium monocristallin de type N (1) ;
le dépôt de premières couches de silicium amorphe de type N (7) sur les premières surfaces des troisièmes couches de passivation en silicium amorphe intrinsèque (5), et le dépôt de secondes couches de silicium amorphe de type N (8) sur des secondes surfaces des quatrièmes couches de passivation en silicium amorphe intrinsèque (6),
dans lequel l'étape de fourniture du premier masque (13), l'étape de gravure et l'étape de dépôt des premières couches de silicium amorphe de type N (7) et des secondes couches de silicium amorphe de type N (8) sont mises en œuvre de telle sorte que les secondes couches de silicium amorphe de type P (42) sont en correspondance univoque avec les premières couches de silicium amorphe de type N (7), et les secondes couches de silicium amorphe de type N (8) sont en correspondance univoque avec les premières couches de silicium amorphe de type P (41), et
dans lequel l'étape de dépôt des troisièmes couches de passivation en silicium amorphe intrinsèque (5) est mise en œuvre de telle sorte que des espaceurs sont fournis entre les premières couches de silicium amorphe de type N (7) et les premières couches de silicium amorphe de type P (41), l'étape de dépôt de quatrièmes couches de passivation en silicium amorphe intrinsèque (6) est mise en œuvre de telle sorte que des espaceurs sont fournis entre les secondes couches de silicium amorphe de type N (8) et les secondes couches de silicium amorphe de type P (42) ;
le retrait du premier masque (13) ;
la fourniture d'un second masque (14) sur la première surface et la seconde surface de la couche de silicium monocristallin de type N (1) ;
le dépôt de premières couches conductrices transparentes (9) sur la première surface de la couche de silicium monocristallin de type N (1) et le dépôt de secondes couches conductrices transparentes (10) sur la seconde surface de la couche de silicium monocristallin de type N (1),
dans lequel l'étape de fourniture du second masque (14) et l'étape de dépôt des couches conductrices transparentes sont mises en œuvre de telle sorte que la pluralité des premières couches conductrices transparentes (9) sont espacées les unes des autres dans la direction longitudinale de la couche de silicium monocristallin de type N (1), et configurées pour connecter électriquement l'une quelconque des premières couches de silicium amorphe de type P (41) à une première couche de silicium amorphe de type N (7) adjacente au niveau d'un premier côté, et de telle sorte que la pluralité des secondes couches conductrices transparentes (10) sont espacées les unes des autres dans la direction longitudinale de la couche de silicium monocristallin de type N (1), et configurées pour connecter électriquement l'une quelconque des secondes couches de silicium amorphe de type N (8) à une seconde couche de silicium amorphe de type P (42) adjacente au niveau d'un second côté opposé au premier côté ; et
la formation d'une première ligne de grille métallique (11) sur une première surface de la pluralité de premières couches conductrices transparentes (9), et la formation d'une seconde ligne de grille métallique (12) sur une seconde surface de la pluralité de secondes couches conductrices transparentes (10).

12. Procédé selon la revendication 11, dans lequel lorsque les couches de silicium amorphe de type P sont gravées, la première couche de passivation en silicium amorphe intrinsèque (2) et la deuxième couche de passivation en silicium amorphe intrinsèque (3) sont gravées pour obtenir une première rainure avec une profondeur supérieure à une épaisseur de la couche de silicium amorphe de type P.

13. Procédé selon la revendication 11 ou 12, dans lequel la première ligne de grille métallique (11) est imprimée ou électrodéposée sur la première surface de la pluralité de premières couches conductrices transparentes (9), et la seconde ligne de grille métallique (12) est imprimée ou électrodéposée sur la seconde surface de la pluralité de secondes couches conductrices transparentes (10).

14. Procédé permettant de fabriquer une cellule à hétérojonction (100), comprenant :
le dépôt d'une première couche de passivation en silicium amorphe intrinsèque (2) sur une première surface d'une couche de silicium monocristallin de type N (1), et le dépôt d'une deuxième couche de passivation en silicium amorphe intrinsèque (3) sur une seconde surface de la couche de silicium monocristallin de type N (1) ;
le dépôt d'une couche de silicium amorphe de type N sur une première surface de la première couche de passivation en silicium amorphe intrinsèque (2) et sur une seconde surface de la deuxième couche de passivation en silicium amorphe intrinsèque (3) ;
la fourniture d'un premier masque (13) sur la première surface et la seconde surface de la couche de silicium monocristallin de type N (1) ;
la gravure des couches de silicium amorphe de type N pour former des premières couches de silicium amorphe de type N (7) et des secondes couches de silicium amorphe de type N (8), respectivement ;
le dépôt de troisièmes couches de passivation en silicium amorphe intrinsèque (5) au niveau de positions de gravure sur la première surface de la couche de silicium monocristallin de type N (1) et le dépôt de quatrièmes couches de passivation en silicium amorphe intrinsèque (6) au niveau de positions de gravure sur la seconde surface de la couche de silicium monocristallin de type N (1) ;
le dépôt de premières couches de silicium amorphe de type P (41) sur les premières surfaces des troisièmes couches de passivation en silicium amorphe intrinsèque (5), et le dépôt de secondes couches de silicium amorphe de type P (42) sur des secondes surfaces des quatrièmes couches de passivation en silicium amorphe intrinsèque (6),
dans lequel l'étape de fourniture du premier masque (13), l'étape de gravure et l'étape de dépôt des premières couches de silicium amorphe de type P (41) et des secondes couches de silicium amorphe de type P (42) sont mises en œuvre de telle sorte que les secondes couches de silicium amorphe de type P (42) sont en correspondance univoque avec les premières couches de silicium amorphe de type N (7), et les secondes couches de silicium amorphe de type N (8) sont en correspondance univoque avec les premières couches de silicium amorphe de type P (41), et
dans lequel l'étape de dépôt des troisièmes couches de passivation en silicium amorphe intrinsèque (5) est mise en œuvre de telle sorte que des espaceurs sont fournis entre les premières couches de silicium amorphe de type N (7) et les premières couches de silicium amorphe de type P (41), l'étape de dépôt de quatrièmes couches de passivation en silicium amorphe intrinsèque (6) est mise en œuvre de telle sorte que des espaceurs sont fournis entre les secondes couches de silicium amorphe de type N (8) et les secondes couches de silicium amorphe de type P (42) ;
le retrait du premier masque (13) ;
la fourniture d'un second masque (14) sur la première surface et la seconde surface de la couche de silicium monocristallin de type N (1) ;
le dépôt d'une pluralité de premières couches conductrices transparentes (9) sur la première surface de la couche de silicium monocristallin de type N (1) et le dépôt d'une pluralité de secondes couches conductrices transparentes (10) sur la seconde surface de la couche de silicium monocristallin de type N (1),
dans lequel l'étape de fourniture du second masque (14) et l'étape de dépôt des couches conductrices transparentes sont mises en œuvre de telle sorte que la pluralité des premières couches conductrices transparentes (9) sont espacées les unes des autres dans la direction longitudinale de la couche de silicium monocristallin de type N (1), et configurées pour connecter électriquement l'une quelconque des premières couches de silicium amorphe de type P (41) à une première couche de silicium amorphe de type N (7) adjacente au niveau d'un premier côté, et de telle sorte que la pluralité des secondes couches conductrices transparentes (10) sont espacées les unes des autres dans la direction longitudinale de la couche de silicium monocristallin de type N (1), et configurées pour connecter électriquement l'une quelconque des secondes couches de silicium amorphe de type N (8) à une seconde couche de silicium amorphe de type P (42) adjacente au niveau d'un second côté opposé au premier côté ; et
la formation d'une première ligne de grille métallique (11) sur une première surface de la pluralité de premières couches conductrices transparentes (9), et la formation d'une seconde ligne de grille métallique (12) sur une seconde surface de la pluralité de secondes couches conductrices transparentes (10).
